# DEMANDE DE BREVET EUROPEEN

(11) **EP 1 193 849 A1**
(43) Date de publication de la demande: **03.04.2002**
(21) Numéro de dépôt: 01402449.1
(22) Date de dépôt: 25.09.2001
(51) Int. Cl.: H02M 3/156, H03K 17/16

(54) **Circuit d'alimentation à résonance à faibles émissions electromagnetiques**

(30) Priorité: 27.09.2000 FR 0012276
(71) Demandeur: MAGNETI MARELLI FRANCE, 92000 Nanterre (FR)
(72) Inventeur: Lecrux, Eric, 78190 Trappes (FR)
(74) Mandataire: Texier, Christian

(57) **Abrégé**

L'invention concerne un circuit d'alimentation à résonance comprenant un élément inductif (10) et un élément capacitif (20) montés en série pour résonner ensemble, ainsi qu'un commutateur à semi-conducteur (30) prévu pour bloquer ou autoriser la résonance selon son état ouvert ou fermé, caractérisé en ce que le commutateur (30) est placé en série entre l'inductance (10) et la capacité (20), et le circuit inclut des moyens (50) pour bloquer une décharge capacitive de la borne de commande (G) du commutateur 30 par rapport à l'une de ses bornes actives (D, S), de sorte qu'une ondulation se trouvant sur cette borne active (S) se trouve reportée sur la borne de commande (G).

## Description

L'invention concerne les alimentations à résonance utilisées dans les véhicules automobiles, notamment pour alimenter des tableaux de bord, des lampes diverses, ou encore pour transporter une énergie électrique sous forme du signal alternatif à bord d'un véhicule.

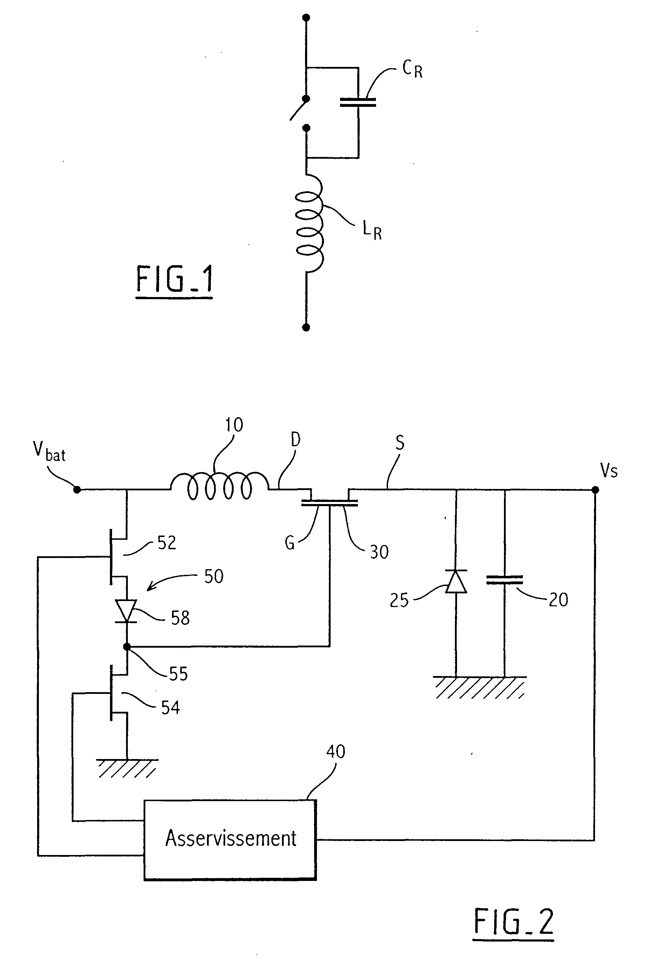

On a représenté à la figure 1 un tel circuit, de type connu.

Ce circuit se compose d'une capacité C_{R} et d'une inductance L_{R} montées en série, et d'un interrupteur à semi-conducteur placé aux bornes de la capacité C_{R}.

Un inconvénient majeur d'un tel circuit à résonance est qu'il émet des perturbations électromagnétiques. Ces perturbations sont dues à un signal de commande appliqué sur l'interrupteur dont la forme carrée inclut des harmoniques à des fréquences gênantes.

On a proposé d'appliquer sur la borne de commande de l'interrupteur un signal de commande de forme sinusoïdale, obtenu à l'aide d'un second circuit LC. Toutefois, ce type de montage s'avère coûteux, et de plus les perturbations électromagnétiques se retrouvent cette fois au niveau d'éléments de commande de ce second circuit LC.

On connaît également le principe des pompes à diodes qui, bien qu'ayant certains avantages, constituent néanmoins un circuit particulièrement rayonnant.

De tels circuits de l'art antérieur nécessitent en outre des circuits écréteurs qui sont coûteux et encombrants.

L'invention propose un circuit à résonance n'émettant que des perturbations électromagnétiques faibles.

Ce but est atteint selon l'invention grâce à un circuit d'alimentation à résonance comprenant un élément inductif et un élément capacitif montés en série pour résonner ensemble, ainsi qu'un commutateur à semi-conducteur prévu pour bloquer ou autoriser la résonance selon son état ouvert ou fermé, caractérisé en ce que le commutateur est placé en série entre l'inductance et la capacité, et le circuit inclut des moyens pour bloquer une décharge capacitive de la borne de commande du commutateur par rapport à l'une de ses bornes actives, de sorte qu'une ondulation se trouvant sur cette borne active se trouve reportée sur la borne de commande.

D'autres caractéristiques, buts et avantages de la présente invention apparaîtront à la lecture de la description détaillée qui va suivre, faite en référence aux figures annexées sur lesquelles :
- la figure 1 représente un circuit à résonance selon l'état de la technique ;
- la figure 2 représente de manière simplifiée un circuit à résonance selon l'invention ;
- la figure 3 est un tracé qui représente l'évolution d'un signal de commande et d'un signal de sortie d'un interrupteur du circuit de la figure 2 ;
- la figure 4 est un schéma de montage détaillé d'un circuit à résonance selon l'invention.

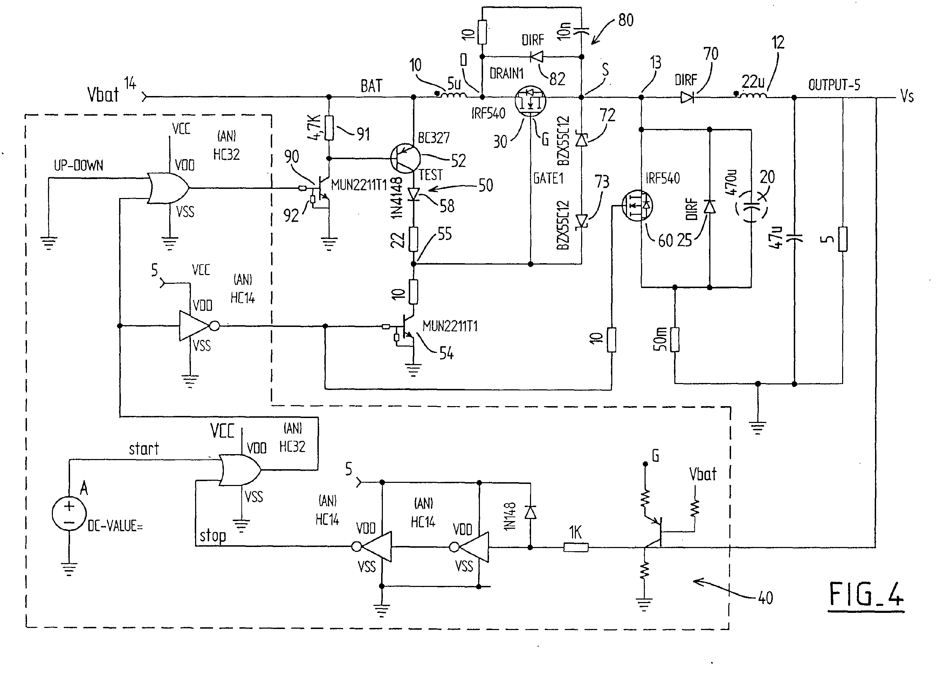

Les circuits à résonance présentés aux figures 2 et 4 comportent, de manière classique, une inductance 10 en série avec un condensateur 20, placés tous deux entre une source de tension (la tension V_{bat}), et la masse.

De manière classique, une diode 25 est placée en parallèle du condensateur 20, passante de la masse vers la source de tension V_{bat}.

Ce circuit présente en outre un commutateur à semi-conducteur 30, placé ici entre l'inductance 10 et le condensateur 20. Le commutateur 30 est alternativement ouvert et fermé. A chaque fermeture, il autorise l'apparition d'un courant résonant et d'une tension résonnante V_{S} sur une sortie située entre le condensateur 10 et la capacité 20.

Cette tension V_{S} décrit une demi-sinusoïde positive. Pour que V_{S} ne présente globalement que des valeurs positives, la diode 25 empêche que la tension V_{S} ne prenne des valeurs négatives et un circuit de contrôle 40, qui commande les ouvertures et fermetures du commutateur 30, commande l'ouverture de l'interrupteur 30 à la fin de la demi-sinusoïdale positive, lorsqu'il détecte le passage au niveau zéro de la tension V_{S}. L'ensemble forme donc un circuit à découpage à résonance.

Le module 40 remplit également une fonction d'asservissement. Il provoque l'ouverture de l'interrupteur 30 de manière plus ou moins fréquente selon la valeur moyenne de la tension V_{S}, afin de caler cette tension moyenne sur une valeur souhaitée.

Ce circuit comporte en outre, entre le module 40 et une borne de commande G (gate) du commutateur 30, un circuit 50 prévu pour générer un signal carré, sous la commande du module 40.

Ce circuit 50 est composé de deux commutateurs à semi-conducteur 52 et 54 placés en série entre la source de tension V_{bat} et la masse. Un point situé entre ces deux commutateurs 52 et 54 est relié à la borne de commande G du commutateur 30. Les bornes de commande de ces deux commutateurs 52 et 54 sont reliées toutes deux au module de commande 40. Le module 40 transmet en permanence des tensions inversées sur les bornes de commande de ces deux commutateurs, de sorte qu'ils sont en permanence dans un état de conduction opposé.

En plaçant l'interrupteur 30 entre l'inductance 10 et le condensateur 20, il s'avère que l'on obtient facilement, sur la borne de commande G de ce commutateur 30, une tension non plus de forme carrée, mais sur laquelle vient se superposer un signal de tension dupliqué à partir du signal de tension présent sur une des bornes actives du commutateur, à savoir sur sa source S ou sur son drain D.

En effet, les commutateurs à semi-conducteur s'avèrent présenter un effet capacitif entre leur borne de commande et l'une quelconque de leurs bornes actives, à savoir leur drain ou leur source, et plus particulièrement entre leur borne de commande et leur borne source.

Une tension apparaissant sur la borne source S lorsqu'elle dépasse en amplitude la valeur de la tension présente sur la borne de commande du commutateur tend à génèrer un courant de décharge entre la borne source et la borne de commande, qui tend à se dissiper dans le circuit où se trouve le commutateur.

Toutefois, dans le présent montage, on retrouve une élévation de tension de la borne source sur la borne de commande G, du fait que cette décharge capacitive est retenue.

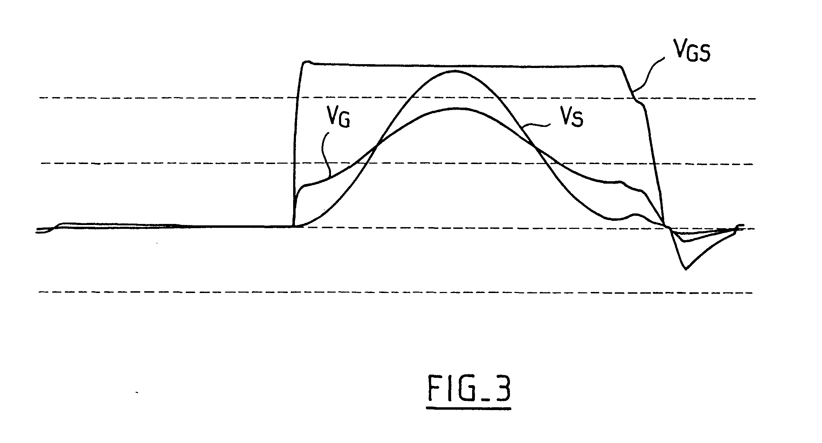

On a représenté à la figure 3 les tensions V_{S} et V_{G} aux points S et G lors d'une phase de fermeture du commutateur 30.

On note bien sur cette figure que la tension au point G présente non pas une forme rectangulaire, mais la forme d'un rectangle auquel vient s'ajouter une ondulation positive dont la forme est sensiblement la même que la tension V_{S}.

Cette ondulation apparaît sur la borne de commande G dans l'état passant du commutateur 30, c'est à dire dans l'état passant du commutateur 52 qui relie la borne de commande G à la tension V_{bat}.

Pour s'assurer que l'on retrouve bien cette ondulation positive sur la borne de commande G, on place une diode 58 qui bloque l'intensité de décharge tendant à remonter de la borne G vers la tension V_{bat}, assurant ainsi que la borne G suit la hausse de voltage apparaissant sur la borne S, au décalage près qui est dû à la charge capacitive présente et maintenue entre G et S. La capacité constituée par l'interrupteur 30 ne peut alors se décharger vers la source de tension V_{bat}, ce qui tendrait à maintenir la tension de commande à la valeur V_{bat}.

On pourrait également remplacer cette diode 58 par un autre élément de blocage, par exemple par un interrupteur à semi-conducteur commandé.

On trouve donc une tension entre les bornes G et S qui reste constante au cours de la phase de conduction du commutateur 30, une tension S qui décrit une demi-sinusoïde positive et une tension G, égale à la somme des tensions V_{bat} et V_{S}, qui présente la forme d'un rectangle auquel s'additionne une ondulation positive.

Les présentes dispositions sont simples à mettre en oeuvre, permettent donc d'obtenir sur la borne de commande G un signal ayant des variations progressives, générant donc de faibles perturbations électromagnétiques.

Les présentes dispositions, en réduisant les émissions électromagnétiques, permettent d'adopter un commutateur 30 nécessitant une tension de commande élevée, par exemple un commutateur de puissance connu sous le sigle IGBT (Insulated Gate Bipolar Transistor) ou encore un commutateur NMOS (Negative Channel Metal Oxyde Semi-conductor) qui requiert typiquement une tension de commande, en particulier une différence de tension entre sa borne de commande et son drain qui est supérieure à 20 Volts.

On utilise ainsi avantageusement un tel commutateur NMOS pour profiter de ses avantages, notamment son faible encombrement, sans souffrir de ses inconvénients.

On a représenté à la figure 4 un schéma de montage détaillé d'un circuit selon l'invention. Ce schéma reprend l'ensemble des éléments précédemment décrits en référence à la figure 2.

Ce circuit présente en outre un commutateur 60 aux bornes du condensateur de résonance 20 et de la diode 25. Ce commutateur 60 est commandé par le module de commande 40. Il forme un court-circuit aux bornes du condensateur 20 de manière synchronisée avec la fermeture du commutateur 54 de mise à la masse. Il annule donc la tension aux bornes du condensateur 20 lorsqu'aucune résonance n'est souhaitée sur la sortie V_{S}.

On note en outre la présence d'une seconde inductance 12, placée entre d'une part le point de liaison du commutateur 30 avec le condensateur 20 et d'autre part la sortie V_{S}. Une diode supplémentaire 70 est également placée en série avec cette inductance 12, entre cette inductance 12 et le commutateur 30 montée passante vers la sortie V_{S}.

On note en outre la présence de deux diodes Zenner 72 et 73 placées en série tête bêche sur une branche qui s'étend entre la borne source S et la borne de commande G du commutateur 30, ayant pour fonction un écrêtage de la différence de tension entre G et S, afin de protéger le commutateur 30.

D'autre part, les bornes actives, c'est à dire les bornes source S et drain D du commutateur 30, sont reliées par une diode 82 montée passante de la source S vers le drain D, en parallèle de laquelle se trouve une branche 80 portant une résistance et un condensateur en série.

On prévoit en outre un étage de commutation supplémentaire 90 en amont de la borne de commande du commutateur 52 relié à la tension d'alimentation V_{bat}. Cet étage 90 se compose d'une branche s'étendant entre V_{bat} et la masse, portant en série une résistance 91 et un commutateur à semi-conducteur 92. Un point situé entre ces deux composants est lié à la borne de commande du commutateur 52 tandis que la borne de commande du commutateur 92 est, elle, alimentée par le module de commande 40.

Le module 40, dans le cas présent, est du type abaisseur, c'est à dire qu'il commande le circuit résonant 10/20 de manière à obtenir en sortie une tension moyenne de V_{S} nettement inférieure à la tension V_{bat}. Dans le cas présent la tension V_{bat} est de 14 Volts et la tension de sortie V_{S} est de 5 Volts.

Le présent circuit a donc ici également pour rôle d'éliminer les variations de la tension V_{bat} (typiquement dans une fourchette allant de 3 à 35 Volts) en une tension V_{S} stable de 5 Volts.

## Revendications

1. Circuit d'alimentation à résonance comprenant un élément inductif (10) et un élément capacitif (20) montés en série pour résonner ensemble, ainsi qu'un commutateur à semi-conducteur (30) prévu pour bloquer ou autoriser la résonance selon son état ouvert ou fermé, **caractérisé en ce que** le commutateur (30) est placé en série entre l'inductance (10) et la capacité (20), et le circuit inclut des moyens (50) pour bloquer une décharge capacitive de la borne de commande (G) du commutateur (30) par rapport à l'une de ses bornes actives (D, S), de sorte qu'une ondulation se trouvant sur cette borne active (S) se trouve reportée sur la borne de commande (G).

2. Circuit selon la revendication 1, **caractérisé en ce que** les moyens (58) pour bloquer la décharge capacitive de la borne de commande du commutateur (30) sont prévus pour effectuer ce blocage sur l'ensemble d'une phase de fermeture du commutateur (30).

3. Circuit d'alimentation selon la revendication 1 ou la revendication 2, **caractérisé en ce que** les moyens de blocage (58) sont placés entre la borne (G) de commande du commutateur (30) et une source de tension (V_{bat}).

4. Circuit d'alimentation selon l'une quelconque des revendications précédentes, **caractérisé en ce qu'**il inclut deux interrupteurs (52, 54) placés respectivement entre la borne (G) de commande du commutateur (30) et une source de tension (V_{bat}) et entre la borne de commande (G) et un point référentiel à une tension différente de celle de la source (V_{bat}), ainsi que des moyens (40) pour commander ces deux interrupteurs (52, 54) alternativement et dans des états de conduction/blocage opposés l'un à l'autre.

5. Circuit d'alimentation selon la revendication 4, **caractérisé en ce que** l'élément de blocage (58) est placé entre la borne de commande (G) du commutateur (30) et ledit interrupteur (52) placé entre la borne de commande (G) et la source de tension (V_{bat}).

6. Circuit selon l'une quelconque des revendications précédentes, **caractérisé en ce que** l'élément de blocage (58) est une diode (58).

7. Circuit selon l'une quelconque des revendications 1 à 5, **caractérisé en ce que** l'élément de blocage (58) est un interrupteur à semi-conducteur.

8. Circuit d'alimentation selon l'une quelconque des revendications précédentes, **caractérisé en ce qu'**il comprend des moyens d'asservissement (40) prévus pour commander une fréquence de fermetures/ouvertures du commutateur (30) en fonction d'une tension moyenne (V_{S}) mesurée en sortie du circuit LC.

9. Circuit d'alimentation selon l'une quelconque des revendications précédentes, **caractérisé en ce que** le commutateur à semi-conducteur (30) est un conducteur MOS.

10. Circuit d'alimentation selon l'une quelconque des revendications précédentes, **caractérisé en ce que** le commutateur à semi-conducteur (30) est un IGBT.
